# FASCICULE DE BREVET EUROPEEN

(11) **EP 4 185 093 B1**
(45) Date de publication et mention de la délivrance du brevet: **25.09.2024**
(21) Numéro de dépôt: 22208479.0
(22) Date de dépôt: 21.11.2022
(51) Int. Cl.: H10N 60/01, G06N 10/00, G06N 10/40

(54) **PROCÉDÉ DE RÉALISATION D'UN DISPOSITIF QUANTIQUE**
VERFAHREN ZUR HERSTELLUNG EINER QUANTENVORRICHTUNG
METHOD FOR MANUFACTURING A QUANTUM DEVICE

(30) Priorité: 22.11.2021 FR 2112297
(43) Date de publication de la demande: 24.05.2023
(73) Titulaire: COMMISSARIAT À L'ÉNERGIE ATOMIQUE ET AUX ÉNERGIES ALTERNATIVES, 75015 Paris (FR)
(72) Inventeur: LE ROYER, Cyrille, 38054 GRENOBLE Cedex 09 (FR); LEFLOCH, François, 38054 GRENOBLE Cedex 09 (FR); NEMOUCHI, Fabrice, 38054 GRENOBLE Cedex 09 (FR); POSSEME, Nicolas, 38054 GRENOBLE Cedex 09 (FR)
(74) Mandataire: Hautier IP

(56) Documents cités:
- US-A1- 2021 143 311
- US-A1- 2021 151 575
- US-A1- 2022 181 536
- US-B1- 11 107 968

## Description

### DOMAINE TECHNIQUE

La présente invention concerne le domaine de l'électronique quantique. Elle trouve pour application particulièrement avantageuse la réalisation de dispositifs quantiques à bits quantiques (appelés quantum bits ou qubits). Une application particulière concerne la réalisation de molécules ou chaînes d'Andreev comprenant une pluralité de régions supraconductrices régulièrement séparées par des barrières couplées entre elles.

### ETAT DE LA TECHNIQUE

Dans le domaine de l'électronique quantique, un bit quantique ou qubit correspond à un état quantique qui représente la plus petite unité de stockage d'information quantique. Cet état quantique est caractérisé par la superposition quantique de plusieurs états, notamment de l'état 0 et de l'état 1. En pratique le bit quantique peut être obtenu par différents dispositifs basés sur différentes architectures. Ainsi, il existe des qubits liés à un état quantique :
- d'un porteur de charge, par exemple le spin d'un électron (qubit de spin),
- d'un courant circulant entre deux régions supraconductrices au travers d'une jonction Josephson, par exemple sa phase (qubit supraconducteur),
- d'un ion piégé ou d'un atome ou d'une molécule, par exemple son niveau énergétique,
- d'un photon, par exemple sa polarisation (qubit photonique).

Chaque type de dispositif possède des avantages intrinsèques et des inconvénients distincts. Par exemple, les dispositifs quantiques à qubits de spin présentent une faible consommation d'énergie en fonctionnement et une fabrication facilitée par les procédés de microélectronique. Ces dispositifs quantiques à qubits de spin présentent néanmoins une intrication de qubits de spin limitée.

Les dispositifs quantiques à qubits supraconducteurs permettent au contraire d'obtenir une bonne intrication entre qubits. Ces dispositifs présentent encore néanmoins une trop grande sensibilité aux variations environnementales.

Pour pallier ces inconvénients, un couplage entre plusieurs régions supraconductrices séparées par des jonctions Josephson a été proposé. Un tel dispositif à qubits supraconducteurs comprenant deux jonctions Josephson couplées en série forme une molécule d'Andreev. Un tel dispositif à qubits supraconducteurs, comprenant plus que deux jonctions Josephson couplées en série, forme typiquement une chaîne d'Andreev.

Le document « Andreev molécules in semiconductor nanowire double quantum dots, Z. Su et al., Nature Communications volume 8, 585 (2017) » décrit une réalisation d'un dispositif quantique à qubits supraconducteurs formant une molécule d'Andreev. Le procédé de réalisation divulgué par ce document n'est cependant pas industrialisable. Il est difficilement reproductible. La densité d'intégration obtenue par ce procédé est en outre très faible.

Il existe donc un besoin consistant à fournir un procédé industriel de réalisation de molécules ou chaînes d'Andreev. Un objet de la présente invention est de répondre à ce besoin.

En particulier, un objet de la présente invention est de proposer un procédé de réalisation d'un dispositif quantique présentant une reproductibilité améliorée. Un autre objet de la présente invention est de proposer un procédé de réalisation d'un dispositif quantique permettant une densité d'intégration élevée.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, un premier aspect de l'invention concerne un procédé de réalisation d'un dispositif quantique, comprenant les étapes suivantes :
- Une formation sur un substrat d'une couche supraconductrice en un matériau supraconducteur, ladite couche supraconductrice s'étendant principalement selon un plan basal xy,
- Une formation d'un masque sur la couche supraconductrice, ledit masque comprenant des motifs de masquage et au moins deux ouvertures en alternance selon une direction dite de conduction du plan xy, lesdites au moins deux ouvertures exposant respectivement au moins deux portions de la couche supraconductrice et étant séparées entre elles selon ladite direction de conduction par une distance de séparation p, lesdites au moins deux ouvertures présentant en outre chacune une largeur d selon ladite direction de conduction, telles que la distance de séparation p et la dimension d soient inférieures à une longueur de cohérence L d'une paire de Cooper dans ledit matériau supraconducteur,
- Une modification, au travers desdites au moins deux ouvertures, desdites au moins deux portions exposées de la couche supraconductrice, de sorte à former au moins deux barrières de largeur d, chaque barrière séparant deux régions supraconductrices de la couche supraconductrice.

La couche supraconductrice est ainsi structurée de façon à former les régions supraconductrices et les barrières en alternance, via les motifs de masquage et les ouvertures du masque. Le procédé permet ainsi de réaliser des molécules ou chaines d'Andreev de façon parfaitement localisée et avec un excellent contrôle dimensionnel. Les procédés de la microélectronique, par exemple le dépôt en couche mince pour la formation de la couche supraconductrice, la lithographie pour la formation du masque, les implantations et/ou les gravures pour la formation des barrières, peuvent être avantageusement mis en oeuvre dans ce procédé de réalisation de dispositif quantique. Cela permet d'obtenir un procédé industriel présentant une excellente reproductibilité. L'utilisation du masque permet également de définir précisément les différentes zones (barrières, régions supraconductrices) avec un contrôle en dimension précis. Cela permet notamment d'obtenir les conditions nécessaires pour le couplage des barrières entre elles, typiquement une distance de séparation p et une dimension d inférieures à une longueur de cohérence L d'une paire de Cooper dans le matériau supraconducteur.

L'utilisation du masque permet en outre, pour une pluralité de dispositifs quantiques, de densifier les dispositifs quantiques. Cela permet également de dédier une zone particulière pour le ou les dispositifs quantiques sur le substrat, en vue d'une co-intégration d'autres dispositifs ou composants microélectroniques sur le même substrat.

Il est fait également référence aux documents US202114331 A1 et US2021151757 A1 portant sur des procédés de fabrication d'un dispositif quantique à fermion de Majorana (MZM) avec détection de charge et au document US11107968 B1 qui porte sur la fabrication d'une jonction Josephson à base de semiconducteurs.

Un aspect de l'invention concerne un procédé de formation d'un système comprenant une pluralité de dispositifs, ledit procédé comprenant au moins un procédé de réalisation d'un dispositif quantique selon le premier aspect de l'invention, et une réalisation d'au moins un autre dispositif pris parmi un dispositif à base de transistors, un dispositif mémoire, un autre dispositif quantique.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre en coupe transverse un dispositif quantique de type chaine d'Andreev selon un mode de réalisation la présente invention.
Les figures 2A à 2D illustrent en coupe transverse des étapes d'un procédé de fabrication d'un dispositif quantique selon un mode de réalisation la présente invention.
Les figures 3A à 3C illustrent en coupe transverse des étapes d'un procédé de fabrication d'un dispositif quantique selon un autre mode de réalisation la présente invention.
Les figures 4A à 4B illustrent en coupe transverse des étapes d'un procédé de fabrication d'un dispositif quantique selon un autre mode de réalisation la présente invention.
La figure 5A illustre en coupe transverse un dispositif quantique selon un mode de réalisation la présente invention.
La figure 5B illustre en vue de dessus le dispositif quantique en partie illustré à la figure 5A, co-intégré avec d'autres dispositifs quantiques, selon un mode de réalisation la présente invention.
La figure 6 illustre en vue de dessus un dispositif quantique co-intégré avec d'autres dispositifs non quantiques, selon un mode de réalisation la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprenant en outre, après formation desdites au moins deux barrières, un retrait au moins partiel du masque.

Selon un exemple, le procédé comprenant en outre, après formation desdites au moins deux barrières, une formation d'au moins un contact sur au moins une région supraconductrice de la couche supraconductrice. Ces contacts permettent typiquement de polariser (en tension) le dispositif et de faire circuler le courant dans le dispositif. Selon un exemple, au moins trois contacts sont formés sur trois régions supraconductrices de la couche supraconductrice. Un ou des contacts intermédiaires peuvent être formés sur la couche supraconductrice le long de la chaîne d'Andreev. Selon un exemple, une grille de contrôle électrostatique est formée le long de la chaîne d'Andreev.

Selon un exemple, la formation du masque comprend les étapes suivantes :
- Un dépôt d'une couche diélectrique sur la couche supraconductrice,
- Une formation de motifs préparatoires en alternance avec au moins deux ouvertures préparatoires dans la couche diélectrique, lesdites au moins deux ouvertures préparatoires présentant chacune une largeur selon la direction x strictement supérieure à la largeur di,
- Une formation, sur au moins un flanc de chacun des motifs préparatoires, d'au moins un espaceur, chaque motif de masquage du masque comprenant un motif préparatoire et au moins un espaceur

Selon un exemple, la formation du masque comprend les étapes suivantes :
- Un dépôt d'une couche diélectrique sur la couche supraconductrice,
- Une formation de motifs préparatoires en alternance avec au moins deux ouvertures préparatoires dans la couche diélectrique, lesdites au moins deux ouvertures préparatoires présentant chacune une largeur di0 selon la direction x strictement supérieure à la largeur di selon la direction x.
- Une formation, sur au moins un flanc de chacun des motifs préparatoires, d'au moins un espaceur de largeur s6i selon la direction x, de sorte à obtenir les au moins deux ouvertures du masque de largeur di, de préférence tel que di = di0 - 2.s6i > 3nm avec 5nm ≤ s6i ≤ 25nm,
chaque motif de masquage du masque comprenant un motif préparatoire et au moins un espaceur. Ainsi, di0 est la largeur initiale des ouvertures préparatoires, avant réduction de taille jusqu'à di par l'utilisation d'espaceurs.

Selon un exemple, les largeurs respectives sont telles que di0 - s6i ≤ di ≤ di0 - 2.s6i. Selon un exemple, les largeurs respectives sont telles que di + 10 nm ≤ di0 ≤ di + 30 nm.

Selon un exemple, la formation du masque est configurée de sorte que la largeur di de chacune des au moins deux ouvertures est inférieure à 100 nm, de préférence inférieure ou égale à 50 nm, et de préférence inférieure ou égale à 20 nm, par exemple comprise entre 3 et 6 nm.

Selon un exemple, la formation de la couche supraconductrice est configurée de sorte que la couche supraconductrice présente une épaisseur e20 selon une direction z normale au plan basal xy, comprise entre 5 nm et 30 nm.

Selon un exemple, la formation de la couche supraconductrice se fait à partir d'une couche de silicium mise en présence d'un gaz BCIx, par une pluralité de tirs laser au sein de la couche de silicium de façon à incorporer du bore pour former le matériau supraconducteur Si:B++.

Selon un exemple, la pluralité de tirs laser comprend au moins 100 tirs laser successifs présentant chacun une durée comprise entre 20ns et 500ns, et une densité d'énergie comprise entre 200 mJ/cm² et 1,5J/cm².

Selon un exemple, la formation de la couche supraconductrice comprend un dépôt d'une couche de nitrure de titane de stoechiométrie contrôlée TiN.

Selon un exemple, le dépôt de la couche de TiN comprend un dépôt assisté par laser pulsé avec un laser infrarouge de longueur d'onde 1064 nm.

Selon un exemple, la formation des barrières comprend une implantation d'espèces dans les portions exposées, de sorte à obtenir un matériau modifié non supraconducteur au niveau de chacune desdites portions, ledit matériau modifié présentant une stoechiométrie différente de celle du matériau supraconducteur non modifié des régions supraconductrices situées de part et d'autre de ladite barrière.

Selon un exemple, la couche supraconductrice est en TiN et l'implantation d'espèces comprend une implantation d'azote.

Selon un exemple, la formation des barrières comprend une amorphisation des portions exposées, de sorte à obtenir un matériau modifié non supraconducteur au niveau de chacune desdites portions, ledit matériau modifié présentant une structure amorphe différente d'une structure cristalline du matériau supraconducteur non modifié des régions supraconductrices situées de part et d'autre de ladite barrière.

Selon un exemple, la couche supraconductrice est à base de silicium dopé bore et l'amorphisation comprend une implantation de germanium à une dose comprise entre 10¹⁵ et 10²⁰ cm⁻².

Selon un exemple, la formation des barrières comprend une gravure de la couche supraconductrice au niveau de chacune desdites portions exposées, selon une direction z normale au plan basal xy et sur une profondeur dp20 supérieure à au moins la moitié d'une épaisseur e20 de la couche supraconductrice, de sorte à obtenir une constriction géométrique en hauteur entre les régions supraconductrices situées de part et d'autre de ladite barrière.

Selon un exemple, la formation des barrières comprend en outre, après ladite gravure de la couche supraconductrice, une épitaxie d'un matériau non supraconducteur entre les régions supraconductrices situées de part et d'autre de ladite barrière.

Selon un exemple, la couche supraconductrice est à base de silicium dopé bore et l'épitaxie comprend une épitaxie de silicium non dopé.

Selon un exemple, après formation des barrières, une couche d'encapsulation à base de nitrure de silicium SiN est formée sur la chaîne d'Andreev.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif, le procédé ou le système, peuvent être adaptées *mutatis mutandis* à un autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, un substrat à base de silicium s'entend par exemple d'un substrat Si, Si dopé, voire SiC ou SiGe.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z. Dans les dessins d'accompagnement, les largeurs sont mesurées selon x.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans un matériau supraconducteur, les porteurs de charge sont appariés localement deux à deux en paire de Cooper. Cet appariement est effectif sur une certaine distance L définissant la taille des paires de Cooper. Cette distance L est nommée longueur de cohérence par la suite. Le matériau acquiert ainsi une phase quantique macroscopique. Si l'on rapproche suffisamment deux régions supraconductrices tout en gardant une mince barrière entre les deux, il est possible de faire traverser les paires de Cooper à travers la barrière tout en préservant leur cohérence quantique. Une telle barrière laissant passer les électrons entre deux régions supraconductrices s'appelle une jonction Josephson (JJ). Il en résulte un courant non-dissipatif dont l'amplitude dépend de la différence de phase des deux supraconducteurs.

Dans le cadre de la présente invention, différents types de jonctions Josephson ou barrières entre deux régions supraconductrices sont envisagés. Une barrière peut être vue comme une description structurelle et une jonction peut être vue comme une description fonctionnelle de la même entité. « Barrières » et « jonctions Josephson » sont ici employées en synonymes. Une barrière s'entend d'une barrière formée d'un matériau non-supraconducteur ou d'un matériau pour lequel la supraconductivité est affaiblie.

La structure des barrières peut se baser, de façon non exhaustive, sur un matériau isolant ou métallique non supraconducteur, ou sur une singularité géométrique ou encore sur un joint de grains. Les jonctions correspondantes peuvent être de type « tunnel », « constriction » ou « point de contact », ou encore une jonction de grains.

Les jonctions à effet tunnel ont typiquement une structure de type SIS (supraconducteur - isolant - supraconducteur) ; dans ces jonctions le mécanisme de transport est essentiellement dominé par l'effet tunnel corrélé des électrons qui forment une paire de Cooper à travers la barrière isolante. Dans une jonction SNS (supraconducteur - métal normal - supraconducteur) le mécanisme de transport est dominé essentiellement par l'effet de proximité. En général à l'interface entre un supraconducteur et un métal normal la cohérence quantique se maintient aussi dans le métal normal sous une distance définie par la longueur de cohérence.

Pour déterminer si une molécule d'Andreev ou une chaîne d'Andreev est réalisée, des mesures électriques à basse température du courant Josephson peuvent être effectuées. En particulier, si la relation de phase quantique du courant Josephson à l'une des extrémités de la chaine peut être modulée par l'amplitude du courant Josephson à l'autre extrémité, cela indique qu'un couplage est effectif entre toutes les barrières. Le dispositif quantique peut alors correspondre à une molécule d'Andreev ou à une chaîne d'Andreev.

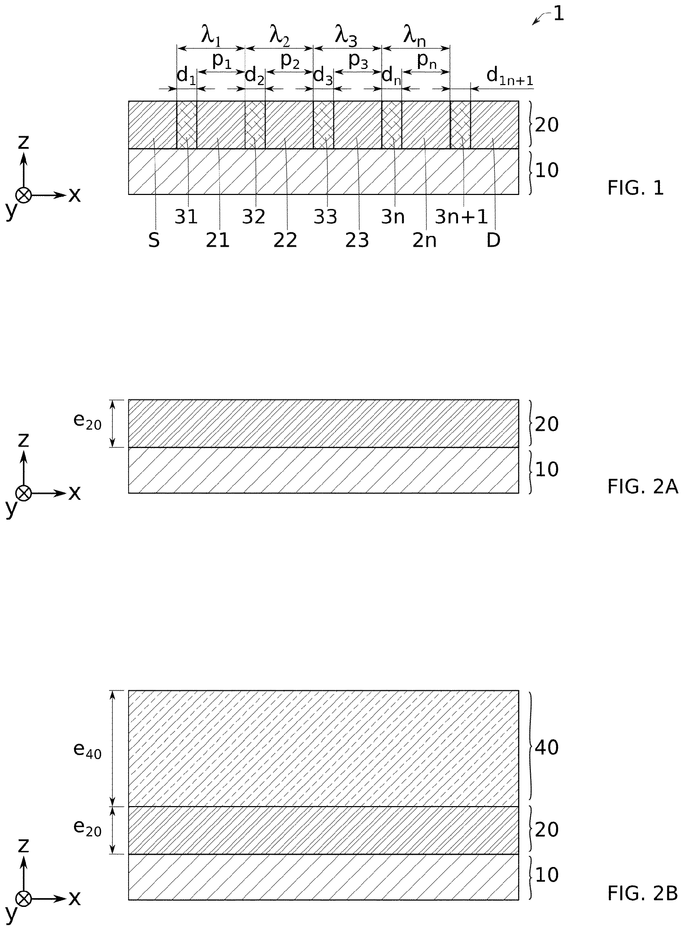

La figure 1 illustre en coupe transverse un mode de réalisation d'un dispositif quantique de type chaine d'Andreev. Ce dispositif quantique 1 comprend une pluralité de régions supraconductrices 21, 22, 23, 2i (i=1... n) séparées les unes des autres par des barrières 31, 32, 33, 3i (i=1 ... n+1). Des régions d'injection de courant, par exemple une région source S et une région drain D sont de préférence situées à chaque extrémité de la chaîne d'Andreev. La source S et le drain D sont typiquement séparés du reste de la chaîne d'Andreev par deux barrières 31, 3n+1 à chaque extrémité de la chaîne d'Andreev.

Chaque barrière 3i présente une largeur di (i=1...n+1) selon x. Chacune des barrières 3i est configurée pour laisser passer les électrons sous forme de paires de Cooper d'une région supraconductrice 2i à une autre région supraconductrice 2i+1. En particulier, chacune des largeurs di est choisie inférieure à la longueur de cohérence L des paires de Cooper au sein du matériau supraconducteur des régions supraconductrices. Selon une possibilité, toutes les largeurs di sont égales entre elles. Alternativement, les largeurs di varient d'un bout à l'autre de la chaîne d'Andreev, par exemple selon une progression monotone, croissante ou décroissante entre la source et le drain. D'autres variations de largeur des barrières sont envisageables, avec di < L. Selon un exemple, les largeurs di sont de préférence inférieures à 100 nm, de préférence inférieures à 50 nm, par exemple comprises entre 3 et 6 nm. Selon un exemple, les largeurs di correspondent à la distance minimale séparant deux régions supraconductrices.

Les régions supraconductrices 21, 22, 23, 2i (i=1... n) sont typiquement formées au sein d'une couche supraconductrice 20, en un matériau supraconducteur. Elles sont physiquement séparées deux à deux par les barrières 31, 32, 33, 3i (i=1... n+1). Elles sont néanmoins connectées entre elles via les jonctions Josephson formées par ces barrières 31, 32, 33, 3i (i=1... n+1). Pour obtenir une molécule d'Andreev ou une chaîne d'Andreev, toutes les barrières sont couplées les unes avec les autres. Cela implique que la distance de séparation pi entre deux barrières, qui correspond à la largeur pi de la région supraconductrice 2i considérée, soit inférieure à la longueur de cohérence L des paires de Cooper. Selon une possibilité, toutes les largeurs pi sont égales entre elles. Alternativement, les largeurs pi varient d'un bout à l'autre de la chaîne d'Andreev, par exemple selon une progression monotone, croissante ou décroissante entre la source et le drain. D'autres variations de largeur des régions supraconductrices sont envisageables, avec pi < L. Selon un exemple, les largeurs pi sont de préférence inférieures à 100 nm, et de préférence inférieures à 50 nm. Selon un exemple, les distances de séparation pi correspondent à la distance minimale séparant deux barrières.

La chaîne d'Andreev présente typiquement une période λi = di + pi. Selon une possibilité, cette période est constante le long de la chaîne. Alternativement, la période peut varier de façon continue ou discontinue, monotone ou non monotone, le long de la chaîne. Selon un exemple, la période λi est comprise entre 40 et 80 nanomètres. Par exemple, λi = 40 nm, di = 20 nm, pi = 20 nm.

La couche supraconductrice 20 est en un matériau supraconducteur. Elle présente une épaisseur e20 inférieure ou égale à 300 nm, de préférence comprise entre 5 et 30 nanomètres. La couche supraconductrice 20 est typiquement portée par un substrat 10.

Le substrat 10 peut-être un substrat massif de silicium, dit « bulk » Si, ou un substrat de type silicium sur isolant SOI (acronyme de « silicon on insulator »). D'autres substrats 10, comprenant par exemple différentes couches ou niveaux métalliques intercalés entre une partie bulk Si et la couche supraconductrice 20, sont également envisageables.

Les figures 2A à 2D présentent un premier mode de réalisation d'une chaine d'Andreev selon le procédé de la présente invention. La première étape de ce procédé consiste à former la couche supraconductrice 20 sur le substrat 10.

Selon une possibilité la couche supraconductrice 20 est à base de nitrure de titane TiN. Elle peut être déposée par des techniques de dépôt physique ou chimique en phase vapeur directement sur le substrat 10. La technique de dépôt est avantageusement choisie de façon à permettre un bon contrôle de la stoechiométrie de la couche supraconductrice en TiN. Le dépôt de TiN supraconducteur peut se faire par dépôt laser pulsé PLD (acronyme de « Pulsed Laser Déposition ») en utilisant un laser pulsé infrarouge à 1064 nm. Des épaisseurs de TiN stoechiométrique comprises entre 5 et 300 nanomètres peuvent être avantageusement obtenues par PLD. La température critique du TiN supraconducteur est typiquement comprise entre 2,45 et 4,8 K. En théorie, la supraconduction du TiN peut être obtenue pour une température critique de l'ordre de 5,6 K.

Selon une autre possibilité, la couche supraconductrice 20 est à base de silicium rendu supraconducteur par incorporation de bore. À partir d'un substrat 10 à base de silicium, une méthode consiste à implanter du bore B via un implanteur, puis à effectuer un recuit laser au niveau de la couche de silicium implantée B, de façon à sursaturer le silicium en bore Si:B++. Une telle méthode est connue sous l'acronyme PLIE signifiant « Pulsed Laser Induced Epitaxy ». Le silicium supraconducteur sursaturé en bore Si:B++ comprend typiquement quelques 10¹⁶ cm⁻².

Une autre méthode consiste à immerger le substrat 10 à base de silicium dans un gaz BCIx, et à effectuer une pluralité de tirs laser pour incorporer le bore dans le silicium. Entre 100 et 200 tirs laser sont typiquement requis pour incorporer le bore dans le silicium de façon à le rendre supraconducteur Si:B++. Une telle méthode est connue sous l'acronyme GILD signifiant « gas immersion laser doping ». De plus amples détails concernant cette méthode GILD peuvent être trouvés dans la référence « C. Marcenat et al., Phys. Rev. B 81, 020501 (2010) ». Cette méthode peut être mise en oeuvre sur bulk Si ou sur SOI. Les épaisseurs de silicium supraconducteur atteignables par cette méthode sont de l'ordre de 20 à 80 nm. Une telle méthode est avantageusement très reproductible et industrialisable.

Après avoir formé la couche supraconductrice 20 sur le substrat 10, un masque comprenant des motifs de masquage et des ouvertures est formé sur la couche supraconductrice. Ce masque peut être typiquement formé par photolithographie.

Comme illustré à la figure 2B, une couche 40 en un matériau diélectrique, par exemple en nitrure de silicium SiN ou en oxyde de silicium SiO2, est déposée sur la couche supraconductrice 20. La couche 40 présente une épaisseur e40 typiquement comprise entre 30 nm et 90 nm. Selon une possibilité cette couche 40 comprend au moins deux sous-couches, par exemple une couche en SiN sur une couche en SiO2, ou inversement une couche en SiO2 sur une couche en SiN. D'autres types de couche 40 de masquage sont également envisageables.

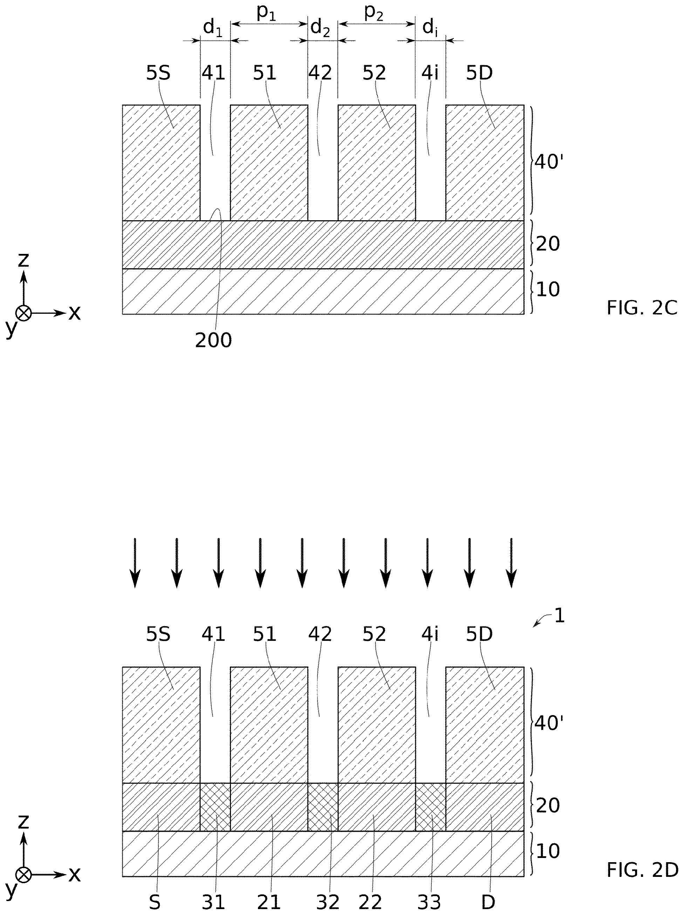

Comme illustré à la figure 2C, des ouvertures 41, 42, 4i (i=1...n1) sont formées dans la couche 40. Ces ouvertures 4i débouchent sur la surface 200 de la couche supraconductrice 20. Les ouvertures 4i séparent des motifs de masquage 5S, 51, 52, 5i (i=1... n), 5D. Dans ce mode de réalisation, les ouvertures 4i sont directement à l'aplomb des futures barrières 3i. Les ouvertures 4i présentent donc la ou les largeurs di (i=1...n+1) selon x. Les motifs de masquage 5i sont directement à l'aplomb des futures régions supraconductrices 2i. Ils présentent donc la ou les largeurs pi (i=1 ... n) selon x. Les ouvertures 4i et les motifs de masquage 5i sont typiquement formés par photolithographie/gravure selon les procédés de la microélectronique bien connus pour ces matériaux et ces dimensions. Le masque ainsi formé est référencé 40' sur les figures.

Comme illustré à la figure 2D, une modification du matériau supraconducteur de la couche supraconductrice 20 est effectuée au travers des ouvertures 4i. Cette modification a pour objectif de rendre le matériau non supraconducteur à l'aplomb des ouvertures 4i. Cette modification permet donc de créer les barrières 3i entre les régions supraconductrices 2i.

Selon un exemple, cette modification se fait par implantation d'espèces, par exemple dans un implanteur ou à partir d'un plasma à couplage inductif ICP (acronyme de « Inductively Coupled Plasma ») au sein d'un réacteur de gravure. Cette implantation est de préférence dirigée selon z. L'implantation se fait de préférence selon toute l'épaisseur e20 de la couche supraconductrice 20. Selon un exemple particulier, pour une couche supraconductrice en TiN, on pourra procéder à une implantation d'azote N. Cela induit un changement de stoechiométrie dans le TiN. Le matériau n'est dès lors plus supraconducteur, de façon localisée sous les ouvertures 4i. On obtient ainsi une jonction Josephson dite SNS (supraconducteur-normal-supraconducteur) entre deux régions supraconductrices 2i.

Selon un autre exemple, la modification est effectuée par amorphisation de la couche supraconductrice 20 à l'aplomb des ouvertures 4i. Cette amorphisation peut se faire de façon classique par implantation d'ions suffisamment lourds, tels que le germanium ou le gallium au sein de la couche supraconductrice 20. L'amorphisation se fait de préférence selon toute l'épaisseur e20 de la couche supraconductrice 20. Selon un exemple particulier, pour une couche supraconductrice à base de Si, cette amorphisation peut se faire par implantation de germanium à une dose comprise entre 10¹⁵ et 10²⁰cm⁻². Cela permet de rompre la continuité de structure cristalline entre les régions supraconductrices 2i. On obtient là encore une jonction Josephson SNS entre deux régions supraconductrices 2i. Une telle barrière 3i par amorphisation peut supporter un budget thermique ultérieur d'environ 500°C. Cela est parfaitement compatible avec les étapes classiques de microélectronique dites de début de ligne ou FEOL (acronyme de « Front End Of Line »). Cela est également compatible avec les étapes classiques de microélectronique dites de fin de ligne ou BEOL (acronyme de « Back End Of Line »).

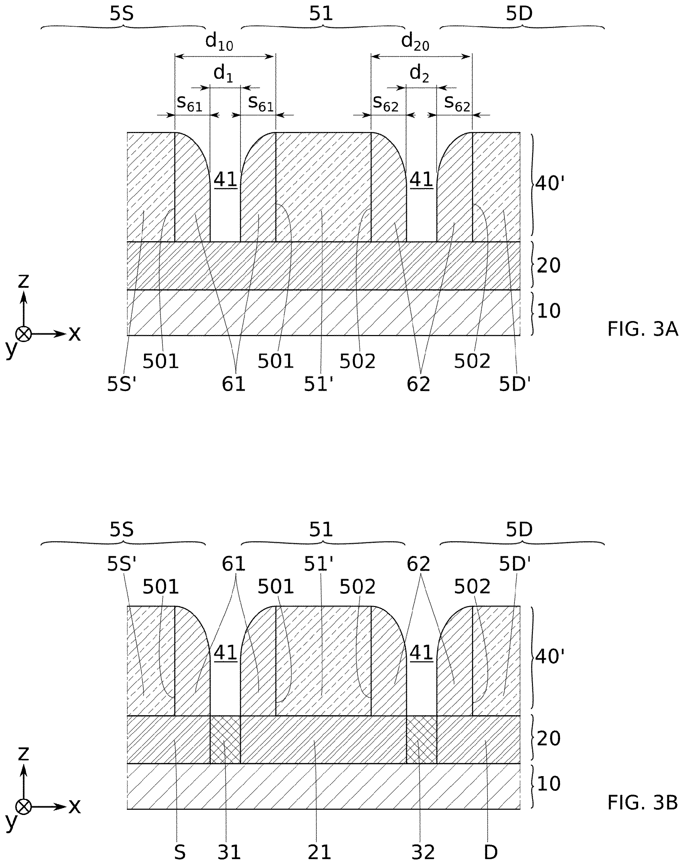

Les figures 3A à 3C illustrent un autre mode de réalisation du procédé selon l'invention. Dans ce mode de réalisation, les motifs de masquage 5S, 5i, 5D et les ouvertures 4i sont formés en deux étapes. Une première étape consiste à former des motifs préparatoires 5S', 5i', 5D' séparés par des ouvertures préparatoires de largeur di0 supérieure à la largeur di des ouvertures 4i finales. Cette première étape peut être effectuée de façon identique au mode de réalisation décrit précédemment et illustré à la figure 2C. Une deuxième étape illustrée à la figure 3A consiste ensuite à former un ou des espaceurs 6i (i=1... n+1) sur au moins un flanc 50i (i=1... n+1), et de préférence sur les deux flancs 50i transverses à la direction x de chaque ouverture préparatoire. La formation des espaceurs permet de réduire la largeur de l'ouverture préparatoire, de façon à obtenir la largeur de l'ouverture finale.

Si l'ouverture préparatoire présente un contour fermé, un seul espaceur 6i peut border le contour fermé de l'ouverture préparatoire. En projection selon z, l'espaceur forme ainsi une bague contre le contour fermé de l'ouverture préparatoire. En coupe transverse selon un plan xz, l'espaceur présente deux parties 6i en vis-à-vis sur chacun des flancs 50i de l'ouverture préparatoire. Ces deux parties sont généralement désignées comme étant les espaceurs, même si celles-ci peuvent être considérées comme appartenant à un seul et même espaceur. Si le motif préparatoire présente un contour fermé, un seul espaceur peut border le contour fermé du motif préparatoire. En projection selon z, l'espaceur forme ainsi une bague autour du motif préparatoire. En coupe transverse selon un plan xz, l'espaceur présente deux parties 6i, 6i+1 en vis-à-vis sur chacun des flancs 50i, 50i+1 du motif préparatoire. Ces deux parties sont généralement désignées comme étant les espaceurs, même si celles-ci peuvent être considérées comme appartenant à un seul et même espaceur.

Selon une possibilité seul l'un des flancs 50i est couvert par un espaceur 6i. Selon une autre possibilité, deux espaceurs distincts couvrent ou bordent chacun des flancs 50i, sans qu'ils forment une bague en projection selon z. Différentes configurations d'espaceurs sont envisageables au sein des ouvertures préparatoires. Après formation du ou des espaceurs, le motif de masquage comprend typiquement le motif préparatoire et le ou les espaceurs.

Ce ou ces espaceurs 6i présentent une largeur s6i selon x, sur le flanc considéré. Ce ou ces espaceurs 6i permettent avantageusement de réduire la largeur di0 de façon à obtenir la largeur di pour l'ouverture 4i correspondante, avec un bon contrôle dimensionnel. Le contrôle dimensionnel sur la largeur di de l'ouverture 4i est amélioré. On obtient ainsi des motifs de masquage 5S, 5i, 5D élargis et des ouvertures 4i dont la largeur di est réduite. La largeur s6i des espaceurs peut être comprise entre 5 nm et 20 nm, de préférence entre 5 nm et 10 nm.

Comme illustré à la figure 3B, après formation des espaceurs 61, 62, 6i, la modification des portions exposées de la couche supraconductrice 20 peut être effectuée, comme précédemment, par implantation et/ou par amorphisation.

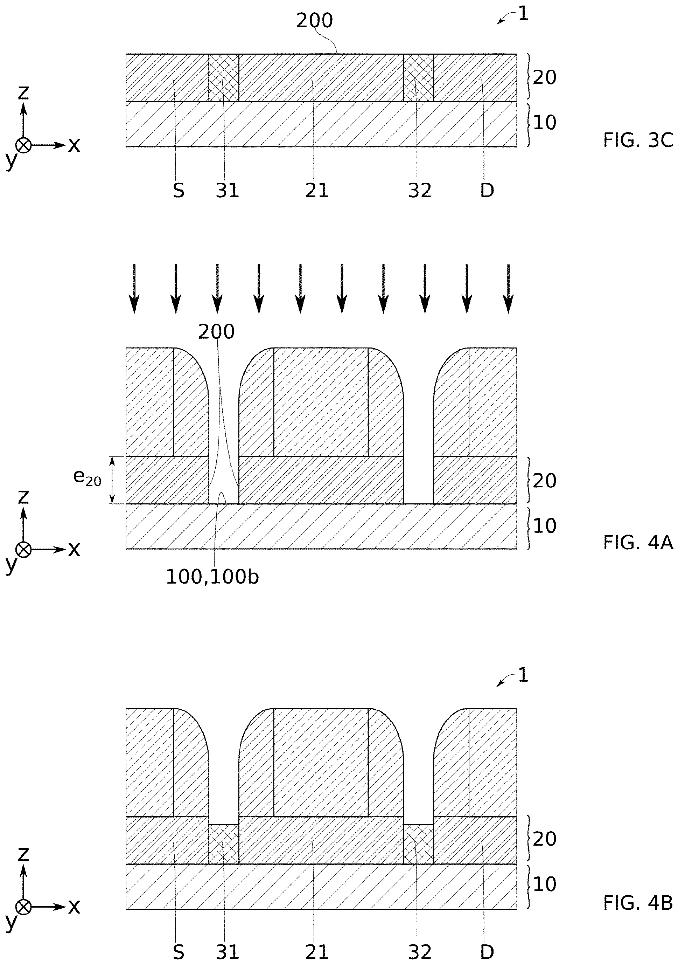

Comme illustré à la figure 3C, après création des barrières, les motifs de masquage peuvent être retirés, de façon à exposer la surface 200 de la couche supraconductrice 20. La source S et le drain D et/ou les régions supraconductrices 2i sont ainsi accessibles, par exemple pour la formation d'électrodes ou de contacts électriques. Selon une possibilité non illustrée, des contacts électriques sont formés sur les source et drain. Selon une autre possibilité, une électrode est formée sur au moins certaines régions supraconductrices 2i.

Les figures 4A à 4B illustrent un autre mode de réalisation du procédé selon l'invention. Dans ce mode de réalisation, la formation des barrières est effectuée en deux étapes. Une première étape consiste à graver la couche supraconductrice 20 sur au moins une partie de la hauteur des portions exposées. Selon un exemple, la couche 20 est gravée partiellement selon z, sur une profondeur dp20 inférieure à une épaisseur e20 de la couche supraconductrice, de sorte à former une constriction selon z dans la couche supraconductrice 20. Ce type de jonction Josephson est appelé jonction constriction SCS (supraconducteur-constriction-supraconducteur).

Dans l'exemple illustré à la figure 4A, les portions exposées de la couche supraconductrice 20 sont gravées selon z sur toute leur hauteur e20, de sorte à exposer des parties 100b de la surface 100 du substrat 10. Des surfaces ou facettes 200b de la couche supraconductrice 20 sont également créées et exposées.

Comme illustré à la figure 4B, les barrières 31, 32, 3i peuvent ensuite être formées par épitaxie à partir de la ou des facettes exposées 100b, 200b. Selon un exemple, elles peuvent être formées par dépôt ou épitaxie d'un matériau non supraconducteur. Selon un exemple, le substrat 10 est à base de Si et la couche supraconductrice 20 est à base de Si:B++, et une épitaxie de silicium intrinsèque ou faiblement dopé est effectuée. Les barrières 31, 32, 3i sont ainsi à base de silicium non supraconducteur. Selon un autre exemple, la ou les facettes 100b du substrat sont à base de SiO2, et l'épitaxie de silicium non supraconducteur se fait latéralement, à partir des seules facettes 200b. Des joints de grains peuvent apparaître lors de l'épitaxie, notamment lors de la jonction de différents fronts de croissance. Les barrières 31, 32, 3i ne présentent pas nécessairement la même hauteur que la couche supraconductrice. Une jonction Josephson SNS et/ou SCS et/ou une jonction de grains peut ainsi être formée.

Sauf incompatibilité, les différentes étapes des modes de réalisation décrits ci-dessus peuvent être combinées, de façon à réaliser un dispositif quantique 1. En particulier, l'utilisation d'espaceurs, le retrait du masque sont des étapes optionnelles pouvant être réalisées pour tous les modes de réalisation. Certaines modifications de la couche supraconductrice peuvent éventuellement être combinées au niveau d'une même portion de couche supraconductrice, par exemple une amorphisation suivie d'une gravure, ou au niveau de différentes portions de couche supraconductrice. Cela peut permettre de former des jonctions hybrides SNS/SCS ou des chaines hybrides SNS/SCS.

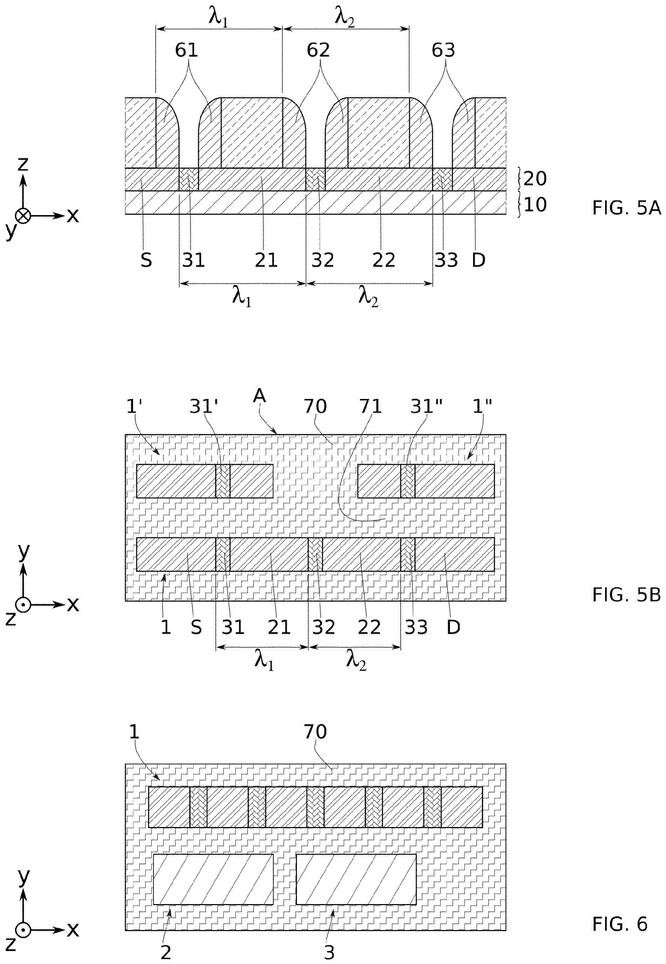

Comme illustré aux figures 5A, 5B, des jonctions Josephson simples, des molécules ou des chaines d'Andreev peuvent être réalisées par ce procédé, de façon industrielle. La vue de dessus illustrée à la figure 5B regroupe différents dispositifs quantiques 1, 1', 1" comprenant des jonctions Josephson 31, 32, 33, 31', 31" formées selon l'un des modes de réalisation du procédé selon l'invention. Ces dispositifs 1, 1', 1" sont disposés sur une même zone A d'un substrat, et isolés les uns des autres, par exemple par un caisson 70 et/ou des tranchées d'isolation 71 en un matériau diélectrique tel que SiO2. Avantageusement, une telle zone comprenant une pluralité de dispositifs quantiques peut présenter de faibles dimensions, par exemple de l'ordre de quelques dizaines de nanomètres à quelques centaines de nanomètres selon y, et de l'ordre de quelques centaines de nanomètres à quelques micromètres selon x. Cela permet d'obtenir une forte densité d'intégration. Des systèmes ou des chaines complexes d'Andreev peuvent ainsi être réalisés. Le procédé selon l'invention est en outre parfaitement compatible avec d'autres étapes de procédé des technologies de la microélectronique.

Selon une possibilité illustrée à la figure 6, le dispositif quantique 1 peut être avantageusement co-intégré avec d'autres dispositifs 2, 3, par exemple des dispositifs 2 basés sur une architecture de transistors CMOS (acronyme de « Complementary Metal Oxide Semiconductor » signifiant transistors complémentaires métal-oxyde-semiconducteur), et/ou des dispositifs 3 de type mémoire RAM (acronyme de « Random Access Memory » signifiant mémoire à accès aléatoire).

D'autres applications peuvent être envisagées.

## Revendications

1. Procédé de réalisation d'un dispositif quantique (1), comprenant les étapes suivantes :
• Une formation sur un substrat (10) d'une couche supraconductrice (20) en un matériau supraconducteur, ladite couche supraconductrice (20) présentant une face (200) s'étendant principalement selon un plan basal xy,
• Une formation d'un masque (40') sur la couche supraconductrice, ledit masque (40') comprenant des motifs de masquage (5S, 51, 52, 53, 5i, 5D) et au moins deux ouvertures (41, 42, 4i) séparées par un motif de masquage et disposées en alternance selon une direction (x) du plan xy, lesdites au moins deux ouvertures (41, 42, 4i) exposant respectivement au moins deux portions de la couche supraconductrice (20) et étant séparées entre elles selon ladite direction (x) par une distance de séparation pi (i=1...n), lesdites au moins deux ouvertures (41, 42, 4i) présentant en outre chacune une largeur di (i=1...n+1) selon ladite direction (x), la distance de séparation pi et la largeur di étant inférieures à une longueur de cohérence L d'une paire de Cooper dans ledit matériau supraconducteur,
• Une modification, au travers desdites au moins deux ouvertures (41, 42, 4i), desdites au moins deux portions exposées de la couche supraconductrice (20), de sorte à former au moins deux barrières (31, 32, 3i) de largeur di, chaque barrière séparant deux régions supraconductrices (21, 22, 2i) de la couche supraconductrice (20).

2. Procédé selon la revendication précédente dans lequel les au moins deux barrières (31, 32, 3i) forment des jonctions de type Josephson.

3. Procédé selon l'une quelconque des revendications précédentes dans lequel la formation du masque (40') comprend les étapes suivantes :
• Un dépôt d'une couche diélectrique (40) sur la couche supraconductrice (20),
• Une formation de motifs préparatoires en alternance avec au moins deux ouvertures préparatoires dans la couche diélectrique (40), lesdites au moins deux ouvertures préparatoires présentant chacune une largeur di0 selon la direction (x) strictement supérieure à la largeur di selon la direction (x),
• Une formation, sur au moins un flanc (501, 502) de chacun des motifs préparatoires, d'au moins un espaceur (61, 62, 6i) de largeur s6i (i=1...n+1) selon la direction (x), de sorte à obtenir les au moins deux ouvertures (41, 42, 4i) du masque (40') de largeur di (i=1...n), de préférence tel que di = di0 - 2.s6i > 3nm avec 5nm ≤ s6i ≤ 25nm,
chaque motif de masquage (5S, 51, 52, 5i, 5D) du masque (40') comprenant un motif préparatoire et au moins un espaceur (61, 62, 6i).

4. Procédé selon l'une quelconque des revendications précédentes dans lequel la formation de la couche supraconductrice (20) se fait à partir d'une couche de silicium mise en présence d'un gaz BCIx, par une pluralité de tirs laser au sein de la couche de silicium de façon à incorporer du bore pour former le matériau supraconducteur Si:B++.

5. Procédé selon l'une quelconque des revendications 1 à 3 dans lequel la formation de la couche supraconductrice (20) comprend un dépôt d'une couche de nitrure de titane de stoechiométrie contrôlée TiN.

6. Procédé selon l'une quelconque des revendications précédentes comprenant en outre, après la formation de la couche supraconductrice (20) et avant la formation des aux moins deux barrières (31, 32, 3i), une structuration de la couche supraconductrice (20) par lithographie et gravure.

7. Procédé selon l'une quelconque des revendications 1 à 5 comprenant en outre, après la formation de la couche supraconductrice (20) et après la formation des aux moins deux barrières (31, 32, 3i), une structuration de la couche supraconductrice (20) par lithographie et gravure.

8. Procédé selon l'une quelconque des revendications précédentes dans lequel la formation des barrières (31, 32, 3i) comprend une implantation d'espèces dans les portions exposées, de sorte à obtenir un matériau modifié non supraconducteur au niveau de chacune desdites portions, ledit matériau modifié présentant une stoechiométrie différente de celle du matériau supraconducteur non modifié des régions supraconductrices (21, 22, 2i) situées de part et d'autre de ladite barrière.

9. Procédé selon la revendication précédente dans lequel la couche supraconductrice (20) est en TiN et l'implantation d'espèces comprend une implantation d'azote.

10. Procédé selon l'une quelconque des revendications précédentes dans lequel la formation des barrières (31, 32, 3i) comprend une amorphisation des portions exposées, de sorte à obtenir un matériau modifié non supraconducteur au niveau de chacune desdites portions, ledit matériau modifié présentant une structure amorphe différente d'une structure cristalline du matériau supraconducteur non modifié des régions supraconductrices (21, 22, 2i) situées de part et d'autre de ladite barrière.

11. Procédé selon la revendication précédente dans lequel la couche supraconductrice (20) est à base de silicium dopé bore et l'amorphisation comprend une implantation de germanium à une dose comprise entre 1015 et 1020 cm-2.

12. Procédé selon l'une quelconque des revendications précédentes dans lequel la formation des barrières (31, 32, 3i) comprend une gravure de la couche supraconductrice (20) au niveau de chacune desdites portions exposées, selon une direction z normale au plan basal xy et sur une profondeur dp20 supérieure à au moins la moitié d'une épaisseur e20 de la couche supraconductrice (20), de sorte à obtenir une constriction géométrique en hauteur entre les régions supraconductrices (21, 22, 2i) situées de part et d'autre de ladite barrière.

13. Procédé selon la revendication précédente dans lequel la formation des barrières (31, 32, 3i) comprend en outre, après ladite gravure de la couche supraconductrice (20), une épitaxie d'un matériau non supraconducteur entre les régions supraconductrices (21, 22, 2i) situées de part et d'autre de ladite barrière.

14. Procédé selon la revendication précédente dans lequel la couche supraconductrice (20) est à base de silicium dopé bore et l'épitaxie comprend une épitaxie de silicium non dopé.

15. Procédé de formation d'un système comprenant une pluralité de dispositifs (1, 1', 1", 2, 3), comprenant au moins un procédé de réalisation d'un dispositif quantique (1) selon l'une quelconque des revendications précédentes, et une réalisation d'au moins un autre dispositif pris parmi un dispositif à base de transistors (2), un dispositif mémoire (3), un autre dispositif quantique (1', 1").

## Patentansprüche

1. Verfahren zur Herstellung einer Quantenvorrichtung (1), die folgenden Schritte umfassend:
• eine Bildung, auf einem Substrat (10), einer supraleitenden Schicht (20) aus einem supraleitenden Material, wobei die supraleitende Schicht (20) eine Fläche (200) aufweist, die sich hauptsächlich entlang einer basalen Ebene xy erstreckt,
• eine Bildung einer Maske (40') auf der supraleitenden Schicht, wobei die Maske (40') Maskierungsmuster (5S, 51, 52, 53, 5i, 5D) umfasst und mindestens zwei Öffnungen (41, 42, 4i), die durch ein Maskierungsmuster getrennt sind, und die abwechselnd entlang einer Richtung (x) der xy-Ebene angeordnet sind, wobei die mindestens zwei Öffnungen (41, 42, 4i) mindestens jeweils zwei Abschnitte der supraleitenden Schicht (20) freilegen, und zwischen sich entlang der Richtung (x) durch einen Trennungsabstand pi (i=1...n) voneinander getrennt sind, wobei die mindestens zwei Öffnungen (41, 42, 4i) ferner eine Breite di (i=1...n+1) entlang der Richtung (x) aufweisen, wobei der Trennungsabstand pi und die Breite di kleiner als eine Kohärenzlänge L eines Cooper-Paares im supraleitenden Material sind,
• eine Modifikation, durch die mindestens zwei Öffnungen (41, 42, 4i) hindurch, der mindestens zwei freigelegten Abschnitte der supraleitenden Schicht (20), so dass mindestens zwei Barrieren (31, 32, 3i) der Breite di gebildet werden, wobei jede Barriere zwei supraleitende Bereiche (21, 22, 2i) der supraleitenden Schicht (20) trennt.

2. Verfahren nach dem vorhergehenden Anspruch, wobei die mindestens zwei Barrieren (31, 32, 3i) Verbindungen vom Typ Josephson bilden.

3. Verfahren nach einem der vorhergehenden Ansprüche, wobei das Bilden der Maske (40') die folgenden Schritte umfasst:
• eine Abscheidung einer dielektrischen Schicht (40) auf der supraleitenden Schicht (20),
• eine Bildung von Vorbereitungsmustern in Abwechslung mit mindestens zwei Vorbereitungsöffnungen in der dielektrischen Schicht (40), wobei die mindestens zwei Vorbereitungsöffnungen jeweils eine Breite di0 entlang der Richtung (x) aufweisen, die streng größer ist als die Breite di entlang der Richtung (x),
• eine Bildung, an mindestens einer Flanke (501, 502) jedes der Vorbereitungsmuster, von mindestens einem Abstandshalter (61, 62, 6i) der Breite s6i (i=1...n+1) entlang der Richtung (x), so dass mindestens die zwei Öffnungen (41, 42, 4i) der Maske (40') mit der Breite di (i=1...n) erhalten werden, vorzugsweise so, dass di = di0 - 2.s6i > 3nm mit 5nm ≤ s6i ≤ 25nm,
wobei jedes Maskierungsmuster (5S, 51, 52, 5i, 5D) der Maske (40') ein Vorbereitungsmuster und mindestens einen Abstandshalter (61, 62, 6i) umfasst.

4. Verfahren nach einem der vorhergehenden Ansprüche, wobei die Bildung der supraleitenden Schicht (20) ausgehend von einer Siliziumschicht, die mit einem BClx-Gas in Kontakt gebracht wird, erfolgt, durch eine Vielzahl von Laserschüssen innerhalb der Siliziumschicht, um Bor einzubauen, um das supraleitende Material Si:B++ zu bilden.

5. Verfahren nach einem der Ansprüche 1 bis 3, wobei die Bildung der supraleitenden Schicht (20) eine Abscheidung einer Schicht aus Titannitrid mit TiN-kontrollierter Stöchiometrie umfasst.

6. Verfahren nach einem der vorhergehenden Ansprüche, ferner umfassend, nach der Bildung der supraleitenden Schicht (20) und vor der Bildung der mindestens zwei Barrieren (31, 32, 3i), eine Strukturierung der supraleitenden Schicht (20) durch Lithographie und Ätzung.

7. Verfahren nach einem der Ansprüche 1 bis 5, ferner umfassend, nach der Bildung der supraleitenden Schicht (20) und nach der Bildung der mindestens zwei Barrieren (31, 32, 3i), eine Strukturierung der supraleitenden Schicht (20) durch Lithographie und Ätzung.

8. Verfahren nach einem der vorhergehenden Ansprüche, wobei die Bildung der Barrieren (31, 32, 3i) eine Implantation von Spezies in die freigelegten Abschnitte umfasst, so dass an jedem der Abschnitte ein modifiziertes nicht-supraleitendes Material erhalten wird, wobei das modifizierte Material eine andere Stöchiometrie aufweist als das nicht modifizierte supraleitende Material der supraleitenden Bereiche (21, 22, 2i), die sich auf beiden Seiten der Barriere befinden.

9. Verfahren nach dem vorhergehenden Anspruch, wobei die supraleitende Schicht (20) aus TiN besteht und die Spezies-Implantation eine Stickstoff-Implantation umfasst.

10. Verfahren nach einem der vorhergehenden Ansprüche, wobei die Bildung der Barrieren (31, 32, 3i) eine Amorphisierung der freigelegten Abschnitte umfasst, so dass an jedem der Abschnitte ein modifiziertes nicht-supraleitendes Material erhalten wird, wobei das modifizierte Material eine amorphe Struktur aufweist, die sich von einer kristallinen Struktur des nicht modifizierten supraleitenden Materials der supraleitenden Bereiche (21, 22, 2i) unterscheidet, die sich auf beiden Seiten der Barriere befinden.

11. Verfahren nach dem vorhergehenden Anspruch, wobei die supraleitende Schicht (20) auf Silizium, das mit Bor dotiert ist, basiert, und die Amorphisierung eine Germanium-Implantation in einer Dosis zwischen 1015 und 1020 cm-2 umfasst.

12. Verfahren nach einem der vorhergehenden Ansprüche, wobei die Bildung der Barrieren (31, 32, 3i) eine Ätzung der supraleitenden Schicht (20) an jedem der freigelegten Abschnitte entlang einer z-Richtung umfasst, die senkrecht zur basalen Eben xy ist, und in einer Tiefe dp20, die mindestens die Hälfte einer Dicke e20 der supraleitenden Schicht (20) überschreitet, so dass eine geometrische Höhenverengung zwischen den supraleitenden Bereichen (21, 22, 2i) erhalten wird, die sich auf beiden Seiten der Barriere befinden.

13. Verfahren nach dem vorhergehenden Anspruch, wobei die Bildung der Barrieren (31, 32, 3i) ferner nach der Ätzung der supraleitenden Schicht (20) eine Epitaxie eines nicht-supraleitenden Materials zwischen den supraleitenden Bereichen (21, 22, 2i) umfasst, die sich auf beiden Seiten der Barriere befinden.

14. Verfahren nach dem vorhergehenden Anspruch, wobei die supraleitende Schicht (20) auf Silizium, das mit Bor dotiert ist, basiert, und die Epitaxie eine Epitaxie mit nicht-dotiertem Silizium umfasst.

15. Verfahren zur Bildung eines Systems, das eine Vielzahl von Vorrichtungen (1, 1', 1", 2, 3) umfasst, mindestens ein Verfahren zur Herstellung einer Quantenvorrichtung (1) nach einem der vorhergehenden Ansprüche umfassend und eine Herstellung mindestens einer weiteren Vorrichtung, die ausgewählt ist aus einer transistorbasierten Vorrichtung (2), einer Speichervorrichtung (3) und einer weiteren Quantenvorrichtung (1', 1").

## Claims

1. A method for manufacturing a quantum device (1), comprising the following steps:
• A formation of a superconducting layer (20) made of a superconducting material on a substrate (10), said superconducting layer (20) having a face (200) extending mainly along a basal xy plane,
• A formation of a mask (40') on the superconducting layer, said mask (40') comprising masking patterns (5S, 51, 52, 53, 5i, 5D) and at least two openings (41, 42, 4i) separated by a masking pattern and alternately disposed in a direction (x) of the xy plane, said at least two openings (41, 42, 4i) exposing respectively at least two portions of the superconducting layer (20) and being separated from each other in said direction (x) by a separation distance pi (i=1...n), said at least two openings (41, 42, 4i) each further having a width di (i=1 ...n+1) in said direction (x), the separation distance pi and the width di being less than a coherence length L of a Cooper pair in said superconducting material,
• A modification, through said at least two openings (41, 42, 4i), of said at least two exposed portions of the superconducting layer (20), so as to form at least two barriers (31 32, 3i) of width di, each barrier separating two superconducting regions (21, 22, 2i) of the superconducting layer (20).

2. The method according to the preceding claim, wherein the at least two barriers (31, 32, 3) form Josephson type junctions.

3. The method according to any one of the preceding claims, wherein the formation of the mask (40') comprises the following steps:
• A deposition of a dielectric layer (40) on the superconducting layer (20),
• A formation of alternating preparatory patterns with at least two preparatory openings in the dielectric layer (40), said at least two preparatory openings each having a width di0 in the direction (x) which is strictly greater than the width di in the direction (x),
• A formation, on at least one side (501, 502) of each of the preparatory patterns, of at least one spacer (61, 62, 6i) of width s6i (i=1...n+1) in the direction (x), so as to obtain the at least two openings (41, 42, 4i) of the mask (40') of width di (i=1...n), preferably such that di = di0 - 2.s6i > 3nm with 5nm ≤ s6i ≤ 25nm,
each masking pattern (5S, 51, 52, 5i, 5D) of the mask (40') comprising a preparatory pattern and at least one spacer (61, 62, 6i).

4. The method according to any one of the preceding claims, wherein the formation of the superconducting layer (20) is done from a silicon layer placed in the presence of a BCIx gas, by a plurality of laser shots within the silicon layer so as to incorporate boron to form the superconducting material Si: B++.

5. The method according to any one of claims 1 to 3, wherein the formation of the superconducting layer (20) comprises a deposition of a titanium nitride layer of controlled stoichiometry TiN.

6. The method according to any one of the preceding claims, further comprising, after the formation of the superconducting layer (20) and before the formation of the at least two barriers (31, 32, 3i), a structuring of the superconducting layer (20) by lithography and etching.

7. The method according to any one of claims 1 to 5, further comprising, after the formation of the superconducting layer (20) and after the formation of at least two barriers (31, 32, 3i), a structuring of the superconducting layer (20) by lithography and etching.

8. The method according to any one of the preceding claims, wherein the formation of the barriers (31, 32, 3i) comprises an implantation of species in the exposed portions, so as to obtain a non-superconducting modified material at each of said portions, said modified material having a stoichiometry different from that of the unmodified superconducting material of the superconducting regions (21, 22, 2i) located on either side of said barrier.

9. The method according to the preceding claim, wherein the superconducting layer (20) is made of TiN and the implantation of species comprises an implantation of nitrogen.

10. The method according to any one of the preceding claims, wherein the formation of the barriers (31, 32, 3i) comprises an amorphisation of the exposed portions, so as to obtain a non-superconducting modified material at each of said portions, said modified material having an amorphous structure different from a crystalline structure of the unmodified superconducting material of the superconducting regions (21, 22, 2i) located on either side of said barrier.

11. The method according to the preceding claim, wherein the superconducting layer (20) is based on boron-doped silicon and the amorphisation comprises an implantation of germanium at a dose comprised between 1015 and 1020 cm-2.

12. The method according to any one of the preceding claims, wherein the formation of the barriers (31, 32, 3i) comprises an etching of the superconducting layer (20) at each of said exposed portions, in a direction z normal to the basal xy plane and over a depth dp20 which is greater than at least half of a thickness e20 of the superconducting layer (20), so as to obtain a geometric constriction in height between the superconducting regions (21, 22, 2i) located on either side of said barrier.

13. The method according to the preceding claim, wherein the formation of the barriers (31, 32, 3i) further comprises, after said etching of the superconducting layer (20), an epitaxy of a non-superconducting material between the superconducting regions (21, 22, 2i) located on either side of said barrier.

14. The method according to the preceding claim, wherein the superconducting layer (20) is based on boron-doped silicon and the epitaxy comprises an epitaxy of undoped silicon.

15. The method for forming a system comprising a plurality of devices (1, 1', 1", 2, 3), comprising at least one method for manufacturing a quantum device (1) according to any one of the preceding claims, and a manufacture of at least one other device chosen among a transistor-based device (2), a memory device (3) and another quantum device (1', 1").
